Europäisches Patentamt

European Patent Office

Office européen des brevets

(19)

(11) Publication number: 0 334 499
A2

# (12) EUROPEAN PATENT APPLICATION

(21) Application number: 89302115.4

(22) Date of filing: 02.03.89

(51) Int. Cl.⁴: C08J 5/24

(30) Priority: 25.03.88 JP 39475/88

(43) Date of publication of application:
27.09.89 Bulletin 89/39

(84) Designated Contracting States:
AT BE CH DE ES FR GB GR IT LI LU NL SE

(71) Applicant: JUNKOSHA CO. LTD.
25-25, Miyasaka 2-chome
Setagaya-ku Tokyo 156(JP)

(72) Inventor: Kobayashi, Satoru
927-3, Ohwaza-Takahagi Hitaka-machi
Iruma-gun Saitama(JP)
Inventor: Tanaka, Satoshi
210 White-Coop 20-24 Gion
Sayama-shi Saitama(JP)
Inventor: Suzuki, Masahiro
102 Junnes-Ishida 853-6 Kami-Arai
Tokorozawa-shi Saitama(JP)
Inventor: Hirose, Tetuya Rm 105
1-1 Bellpia-Motokaji 428-3 Maruyama
Ohwaza-Noda
Iruma-shi Saitama(JP)

(74) Representative: Knott, Stephen Gilbert et al
MATHISEN, MACARA & CO. The Coach
House 6-8 Swakeleys Road
Ickenham Uxbridge Middlesex UB10 8BZ(GB)

(54) A prepreg sheet.

(57) A prepreg sheet (1) is provided comprising a dielectric insulating substrate (3), a first semi-hardened adhesive layer (4) impregnating the substrate (3), and a second semi-hardened adhesive layer (5) applied to the surface of the first semi-hardened adhesive layer (4). Preferably the adhesive of the first semi-hardened adhesive layer, prior to hardening, has a higher viscosity than the adhesive of the second semi-hardened adhesive layer, prior to hardening.

Fig.1

## A PREPREG SHEET

The present invention relates to a prepreg sheet (i.e. a semi-hardended dielectric insulating sheet) for use in the formation of metal foil covered printed substrates and in the manufacture of multilayer printed circuit boards.

Prepreg sheets of this type have conventionally been formed by impregnating an insulating substrate with an adhesive resin and then hardening the resin to a semi-hardened state as disclosed, for example, in Japanese Patent Publication No. 62-90808.

When printed circuit boards are laminated, or copper foils are applied using such conventional prepreg sheets, the application of heat and pressure is involved. However, the adhesive resin with the insulating substrate of conventional prepreg sheets is impregnated may flow out of the substrate when heat and pressure are applied. Alternatively, in cases where the impregnation is incomplete, the degree of impregnation of the interior of the insulating substrate may increase, while the amount of adhesive resin in the outer surface layer decreases (or becomes void in the worst case), so that adhesion becomes unpredictable and insufficient.

The present invention is concerned with overcoming these drawbacks and providing a prepreg sheet with improved adhesive properties so that virtually no adhesion problems arise.

To this end, according to the present invention there is provided a prepreg sheet comprising a dielectric insulating substrate, a first semi-hardended adhesive layer impregnating the insulating substrate, and a second semi-hardended adhesive layer applied to the surface of the first semi-hardened adhesive layer.

The dielectric insulating substrate may comprise porous, expanded polytetrafluoroethylene or may be a fabric made of glass fibres.

The first adhesive layer may comprise an epoxy resin adhesive or a polyimide enamel adhesive, and the second adhesive layer may also comprise an epoxy resin adhesive or a polyimide enamel adhesive.

Preferably the adhesive of the first semi-hardened adhesive layer, prior to hardening, has a higher viscosity than the adhesive of the second semi-hardened adheisve layer, prior to hardening.

With a prepreg sheet in accordance with the present invention, bonding with other parts is achieved primarily through the second semi-hardened adhesive layer. If the second semi-hardened adhesive layer should flow out away from the substrate, bonding can still be achieved by the first semi-hardened adhesive layer. Accordingly, complete bonding is substantially guaranteed.

Because the first adhesive layer, which forms an underlayer beneath the semi-hardened second adhesive layer, is also semi-hardened, the two adhesive layers will not flow out away from the substrate or penetrate into the interior of the substrate as long as there is no extreme application of heat or pressure. Accordingly, even if the first adhesive layer is applied so that the impregnation of the substrate is incomplete (i.e. only partial), there are virtually no problems. As a result, an increase in the specific inductive capacity of the sheet can be prevented.

Two embodiments of the prepreg sheet in accordance with the invention will now be described, by way of example only, with reference to the accompanying drawings, in which:

Figure 1 is a diagrammatic, cross-sectional view of a portion of a first embodiment; and,

Figure 2 is a diagrammatic, cross-sectional view of a portion of a second embodiment.

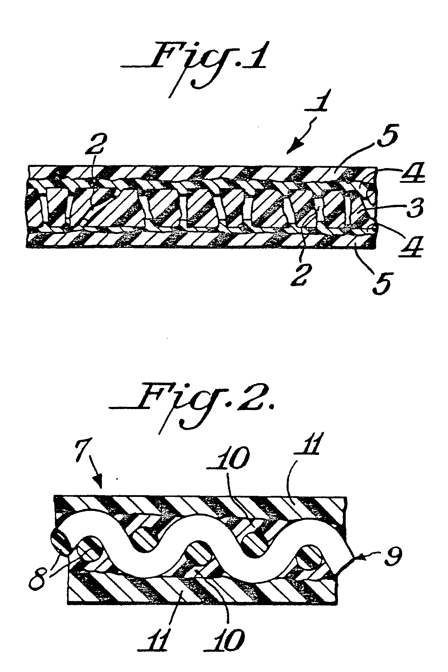

In the first embodiment shown in Figure 1 the prepreg sheet comprises a porous, expanded polytetrafluoroethylene resin sheet 3 as a dielectric insulating substrate, the sheet 3 having a thickness of 50 microns and numerous continuous pores 2 therethrough. A first adhesive resin is applied to both sides of the insulating substrate 3 by coating, impregnation or other means, and after application, this adhesive is subjected to a semi-hardening treatment so that a first semi-hardened adhesive layer 4 is formed. A further adhesive resin coating is then applied to the surface of the first semi-hardened layer 4, and is subjected to a semi-hardening treatment so that a second semi-hardened adhesive layer 5 is formed.

The first semi-hardened adhesive layer 4 generally does not entirely fill all of the pores 2 of the polytetrafluoroethylene resin sheet 3, but instead the adhesive is applied so that it is anchored by a slight penetration into the surface of the sheet. As a result, most of the volume of the pores 2 is maintained as empty space, so that an increase of the specific inductive capacity is substantially prevented. Accordingly, the increase in the specific inductive capacity caused by the application of the first adhesive resin layer 4 can be kept to a minimum.

In the case of the prepreg sheet 1 constructed as just described, the second semi-hardened adhesive layer 5 on both surfaces is maintained by the first semi-hardened adhesive layer 4 so that said second semi-hardened adhesive layer 5 will not flow away from the substrate even if the layer 5 should soften during the bonding of a metal foil or lamination of a printed circuit board thereto. Even if the resin should flow out, adhesion is still accomplished by the first semi-hardened adhesive layer 4, so that the bonding is highly reliable.

In the embodiment shown in Figure 2, a prepreg sheet 7 is illustrated in which the insulating substrate comprises a fabric 9 made of glass fibres 8. An adhesive resin with a relatively high viscosity is applied to the fabric 9, and this resin is subjected to a semi-hardening treatment so that a first semi-hardened adhesive layer 10 is formed. Next, a second semi-hardened adhesive layer 11 comprising a adhesive resin with a relatively low viscosity is formed on the surface of the adhesive layer 10. Since a resin with a relativly high viscosity is used for the first semi-hardened adhesive layer 10, this first resin does not penetrate deeply into the fabric 9. Accordingly, residual air is retained inside the fabric 9, so that a substantial increase of the specific inductive capacity is avoided.

Like the prepreg sheet 1 shown in Figure 1, the prepreg sheet 7 of this embodiment has high bonding reliability.

The present invention is not limited to these examples. Other embodiments are possible within the scope of the present invention. For example, the insulating substrate may be a substrate other than those described above, and any desired adhesive resin may be used. Preferred adhesives are epoxy resin adhesives such as "Epiclon", marketed by Dainippon Ink Chemicals, Inc., and "Epomik", marketed by Mitsui Petrochemical Industries, Ltd. Polyimide enamel adhesives are also suitable.

As described above, the present invention provides a prepreg sheet which comprises an insulating substrate, a first semi-hardened adhesive layer which is applied to the insulating substrate, and a second semi-hardened adhesive layer which is applied to the surface of the first semi-hardened adhesive layer. As a result, the bonding reliability of the prepreg sheet is extremely high. Because the degree of penetration of the first semi-hardened adhesive layer into the substrate can be minimized, a material with a relatively low specific inductive capacity can be obtained.

## Claims

1. A prepreg sheet comprising a dielectric insulating substrate (3;9), and a first semi-hardened adhesive layer (4;10) impregnating said substrate, characterized by a second semi-hardened adhesive layer (5;11) applied to the surface of said first semi-hardened adhesive layer (4;10).

2. A prepreg sheet according to claim 1, wherein said substrate (3) comprises porous, expanded polytetrafluoroethylene.

3. A prepreg sheet according to claim 1, wherein said substrate (9) is a fabric made of glass fibres (8).

4. A prepreg sheet according to any one of the preceding claims, wherein said first adhesive layer (4; 10) comprises an epoxy resin adhesive.

5. A prepreg sheet according to any one of claims 1 to 3, wherein said first adhesive layer (4;10) comprises a polyimide enamel adhesive.

6. A prepreg sheet according to any one of the preceding claims, wherein said second adhesive layer (5;11) comprises an epoxy resin adhesive.

7. A prepreg sheet according to any one of claims 1 to 5, wherein said second adhesive layer (5;11) comprises a polyimide enamel adhesive.

8. A prepreg sheet according to any one of the preceding claims, wherein the adhesive of said first semi-hardened adhesive layer (4;10), prior to hardening, has a higher viscosity than the adhesive of said second semi- hardened adhesive layer (5;11), prior to hardening.

9. A prepreg sheet according to any one of the preceding claims, in which said substrate (3;9) is only partly impregnated by said first adhesive layer (4;10).

*Fig.1*

*Fig.2.*